# FASCICULE DE BREVET EUROPEEN

(11) **EP 1 507 270 B1**
(45) Date de publication et mention de la délivrance du brevet: **14.06.2006**
(21) Numéro de dépôt: 04356144.8
(22) Date de dépôt: 02.08.2004
(51) Int. Cl.: H01C 7/12, G01R 1/26

(54) **Appareil de contrôle du vieillissement d'une varistance**
Gerät zur Prüfung des Alterungsgrades eines Varistors
Apparatus for testing the ageing of a varistor

(30) Priorité: 14.08.2003 FR 0309973
(43) Date de publication de la demande: 16.02.2005
(73) Titulaire: Soule Protection Surtensions, 69100 Villeurbanne (FR)
(72) Inventeur: Serrie, Gérard, 65200 Cieutat (FR)
(74) Mandataire: Martin, Didier Roland Valéry

(56) Documents cités:
- EP-A- 0 660 125
- DE-A- 3 423 444
- US-A- 2 669 004
- US-B1- 6 246 242

## Description

La présente invention se rapporte au domaine technique général des appareils de contrôle du vieillissement des varistances, lesquelles sont notamment utilisées au sein de dispositifs de protection d'installations et d'équipements contre les surtensions, par exemple les surtensions dues à la foudre.

La présente invention concerne plus particulièrement un appareil de contrôle du vieillissement d'une varistance par application d'une tension entre les bornes de ladite varistance.

L'invention concerne également un procédé de contrôle du vieillissement d'une varistance par application d'une tension entre les bornes de ladite varistance.

Les varistances sont couramment utilisées pour protéger des installations électriques et des équipements contre les surtensions. Lorsqu'une surtension se produit au sein de l'installation, la varistance subit un choc de courant qui a pour effet de la dégrader. La dégradation des varistances est difficile, voire impossible à prévoir dans la mesure où elle dépend non seulement du nombre de chocs de courant subis par la varistance au cours de sa vie, mais également de leur amplitude. Il est par conséquent difficile de prévoir *a priori* la durée de vie et le degré de vieillissement d'une varistance, et l'utilisateur est souvent amené à constater *a posteriori* la destruction de cette dernière, de telle sorte que l'installation court le risque de fonctionner pendant un certain temps de latence sans protection.

Pour pallier à cet inconvénient, il est connu de munir l'installation que l'on souhaite protéger d'une varistance supplémentaire de sécurité, montée en parallèle avec une autre varistance. Ainsi, lorsque l'une des deux varistances parvient en fin de vie, et n'est plus en mesure d'assurer sa fonction de protection, l'autre varistance prend le relais de la première et assure à son tour la protection de l'installation. Une telle méthode permet donc d'améliorer sensiblement la sécurité de l'installation, mais souffre tout de même de plusieurs inconvénients.

Tout d'abord, pendant toute la période où la première varistance est défectueuse, l'installation bénéficie d'une protection réduite à une seule varistance jusqu'au remplacement de la varistance défaillante. Dès lors, si un choc de courant d'amplitude très importante, et en tout cas supérieure à la capacité maximale de décharge de la varistance de remplacement se produit, l'installation risque d'être totalement dépourvue de protection, et ce de façon subite et imprévisible.

Par ailleurs, la varistance défectueuse étant automatiquement remplacée par la varistance de remplacement, l'exploitant de l'installation n'est pas toujours à même de constater rapidement que l'une des deux varistances est défaillante. Il peut donc se produire un certain temps de latence avant le remplacement de la varistance défaillante. Avec cette méthode, l'installation ne bénéficie donc pas en permanence d'une protection optimale.

Il est également connu d'utiliser un procédé de contrôle du vieillissement des varistances basé sur la quantification de la dégradation infligée aux varistances par les chocs qu'elles ont subis. Ainsi, la dégradation provoquée par les chocs de courant a pour effet d'abaisser la caractéristique courant-tension, non linéaire, des varistances, c'est-à-dire de diminuer l'impédance des varistance sous une tension donnée. Ce procédé de quantification de la dégradation des varistances est donc basé sur la comparaison de la résistance de la varistance ou, de façon équivalente, de l'intensité du courant traversant la varistance sous une tension donnée et à un instant donné, avec la résistance de la varistance, respectivement l'intensité du courant qui la traversait sous la même tension à l'état neuf. L'augmentation du courant, respectivement la diminution de la résistance entre la mesure à l'état neuf et la mesure à l'état d'usage, est représentative de la dégradation du composant. Un tel procédé de contrôle permet donc de vérifier que l'installation bénéficie en permanence de la protection optimale, et de prévoir la destruction de la varistance.

En revanche, le procédé de contrôle sus-mentionné est peu pratique à mettre en oeuvre dans la mesure où la caractéristique courant-tension des varistances n'est pas identique pour toutes les varistances, mais propre à chaque varistance ou à chaque type de varistance. Un tel procédé nécessite donc une première étape où l'on mesure, avant la mise en place d'une varistance neuve sur l'installation électrique à protéger, la valeur de la résistance ou du courant la traversant sous une tension donnée, cette étape devant être répétée pour chaque dispositif de protection contre les surtensions, et accompagnée d'une étape d'enregistrement de la valeur mesurée de référence, afin de pouvoir contrôler ultérieurement le vieillissement de la varistance. En particulier, la valeur mesurée à l'état neuf peut être indiquée, et par exemple gravée, directement sur le composant. Ainsi, une fois mise en place au sein de l'installation, la varistance peut être régulièrement contrôlée, et on mesure en particulier sa résistance, ou l'intensité du courant la traversant, lorsqu'une tension identique à celle appliquée lors de la mesure effectuée sur la varistance à l'état neuf est appliquée à ses bornes.

Toutes les étapes du procédé sus-mentionné constituent des contraintes importantes non seulement pour l'industriel en charge de la fabrication de la varistance mais encore pour l'exploitant chargé de l'entretien d'une installation électrique, notamment lorsque cette dernière est équipée de nombreux dispositifs de protection contre les surtensions. En particulier, un tel procédé nécessite qu'un technicien contrôle régulièrement le degré de vieillissement des varistances, avec chaque fois un risque d'erreur humaine et/ou d'appareillage non négligeable.

En outre, il est connu d'utiliser un appareil de mesures spécifique dans le cadre de ce procédé de contrôle. Cependant, cet appareil n'est pas conçu pour indiquer directement si la varistance doit être ou non remplacée. Il permet seulement d'effectuer des mesures de résistance de la varistance ou de l'intensité du courant traversant ladite varistance lorsqu'une tension est appliquée à ses bornes. Par conséquent, après la mesure, le technicien chargé du contrôle de l'installation est obligé d'effectuer lui-même un traitement des données fournies par l'appareil de mesure, de telle sorte que toutes ces opérations nécessitent beaucoup de temps, ce qui est souvent peu compatible avec les contraintes d'exploitation d'une installation électrique.

Par ailleurs, un tel procédé nécessite une étape préliminaire contraignante qui consiste à graver, sur chaque composant, sa résistance mesurée à l'état neuf et sous une tension donnée.

US 2 669 004 (Blair) divulgue vu appareil de contrôle du vieillissement d'une varistance.

Les objets assignés à l'invention visent par conséquent à proposer un nouvel appareil de contrôle du vieillissement d'une varistance permettant d'évaluer et d'indiquer avec précision et rapidité le degré de vieillissement d'une varistance, quel que soit son état initial et originel.

Un autre objet de l'invention vise à proposer un nouvel appareil de contrôle du vieillissement d'une varistance qui soit de conception simple et qui permette une lecture facile et directe des résultats des tests de contrôle du vieillissement des varistances.

Un autre objet de l'invention vise à proposer un nouvel appareil de contrôle du vieillissement d'une varistance susceptible d'indiquer directement, après un nombre minimum de manipulations, si la varistance doit ou non être remplacée.

Un autre objet de l'invention vise à proposer un nouvel appareil de contrôle du vieillissement d'une varistance qui ne nécessite pas de démontage de l'installation électrique, notamment en vue de retirer le composant à contrôler.

Un autre objet de l'invention vise à proposer un nouvel appareil de contrôle du vieillissement d'une varistance qui ne provoque aucune perturbation de l'installation.

Un autre objet de l'invention vise à proposer un nouvel appareil de contrôle du vieillissement d'une varistance susceptible d'être utilisé pour des opérations de suivi, de surveillance et de contrôle dans le temps de vieillissement d'une varistance.

Les assignés à l'invention visent également à proposer un nouveau procédé de contrôle du vieillissement d'une varistance qui ne présente pas les inconvénients de l'art antérieur énumérés précédemment, et qui permette d'évaluer avec précision et rapidité le degré de vieillissement d'une varistance quel que soit son état initial et originel.

Un autre objet de l'invention vise à proposer un nouveau procédé de contrôle du vieillissement d'une varistance susceptible d'indiquer de façon directe et claire si la varistance peut encore être utilisée de façon fiable ou si elle doit être remplacée.

Un autre objet de l'invention vise à proposer un nouveau procédé de contrôle du vieillissement d'une varistance qui puisse être appliqué à des opérations de suivi, de surveillance et de contrôle dans le temps du vieillissement d'une varistance.

Les objets assignés à l'invention sont atteints à l'aide d'un appareil de contrôle du vieillissement d'une varistance par application d'une tension entre les bornes de ladite varistance comportant :
- des moyens de génération de tension, agencés pour générer :
   - une première tension présentant une première polarité,
   - une deuxième tension présentant une deuxième polarité opposée à ladite première polarité,
- des moyens de connexion électrique desdits moyens de génération de tension aux bornes de ladite varistance,
- des moyens de mesure d'une part d'une première valeur de la résistance de ladite varistance et/ou de l'intensité du courant passant à travers ladite varistance lorsque la première tension est appliquée aux bornes de cette dernière, et d'autre part d'une deuxième valeur de la résistance de ladite varistance et/ou de l'intensité du courant passant à travers ladite varistance lorsque la deuxième tension est appliquée audites bornes, lesdites première et deuxième valeurs formant une première valeur mesurée et une deuxième valeur mesurée,
- et une unité de traitement électronique agencée de manière à stocker ladite première valeur mesurée, à la comparer à ladite deuxième valeur mesurée et à calculer une valeur d'écart calculée correspondant à la valeur de l'écart entre ladite première valeur mesurée et ladite deuxième valeur mesurée.

Les objets assignés à l'invention sont également atteints à l'aide d'un procédé de contrôle du vieillissement d'une varistance par application d'une tension entre les bornes de ladite varistance, ledit procédé comportant :
- une étape (a) de mesure d'une première valeur de la résistance de ladite varistance et/ou de l'intensité du courant la traversant lorsqu'une première tension est appliquée aux bornes de la varistance selon une première polarité, ladite première valeur formant une première valeur mesurée,
- une étape (b) de mesure d'une deuxième valeur de la résistance de ladite varistance et/ou de l'intensité du courant la traversant lorsqu'une deuxième tension est appliquée aux bornes de la varistance selon une deuxième polarité, ladite deuxième polarité étant opposée à ladite première polarité, et ladite deuxième valeur formant une deuxième valeur mesurée,
- puis une étape (c) de comparaison desdites première et deuxième valeurs mesurées.

D'autres objets et avantages de l'invention apparaîtront mieux à la lecture de la description ci-jointe, ainsi qu'à l'aide des dessins annexés, à titre purement illustratif et informatif, parmi lesquels :
- La figure 1 illustre, selon une vue en perspective, un appareil de contrôle du vieillissement d'une varistance conforme à l'invention destiné à être utilisé pour contrôler une varistance ou une cartouche de protection d'une installation électrique contre les surtensions.
- La figure 2 illustre, selon une vue de face, une représentation schématique simplifiée du montage électrique correspondant à une première étape du procédé de contrôle du vieillissement d'une varistance à l'aide de l'appareil de contrôle conforme à l'invention.
- La figure 3 illustre, selon une vue de face, une représentation schématique simplifiée du montage électrique correspondant à une deuxième étape de contrôle du vieillissement d'une varistance à l'aide de l'appareil de contrôle conforme à l'invention.
- La figure 4 illustre, selon une vue schématique de face, un appareil de contrôle du vieillissement d'une varistance utilisé dans le cadre d'une application de contrôle et de suivi du vieillissement d'une varistance.

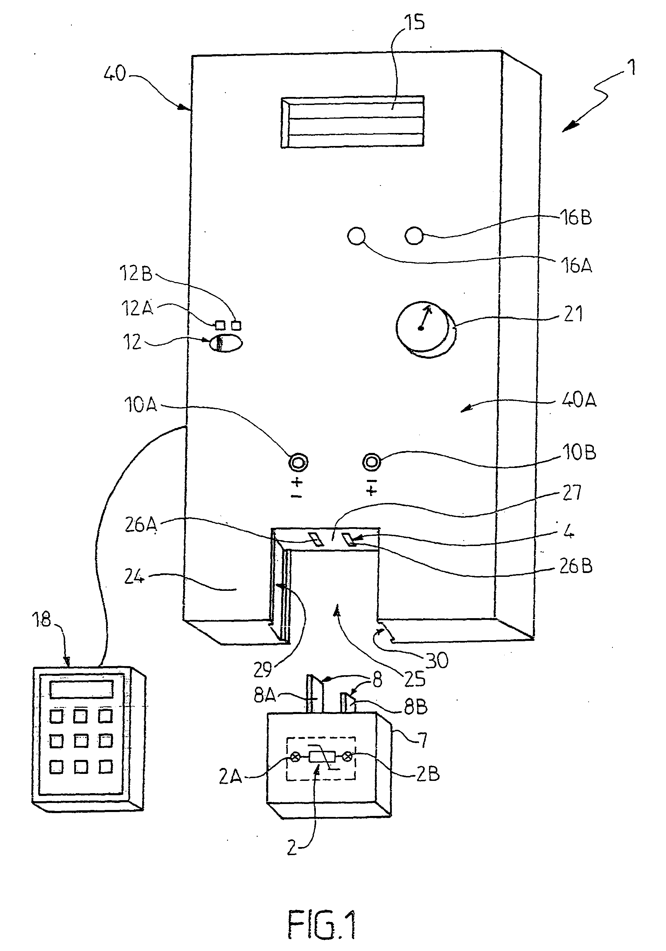

La figure 1 montre un appareil 1 de contrôle du vieillissement d'une varistance 2 par application d'une tension entre les bornes 2A, 2B de la varistance 2.

Au sens de l'invention, une « *varistance* » désigne un composant résistif dont la caractéristique courant-tension est non-linéaire, tel que par exemple une thermistance, une photorésistance ou de façon encore plus préférentielle, une varistance à oxyde métallique (MOV) couramment utilisée dans les dispositifs de protection contre les surtensions. Ce dernier type de varistance est généralement préféré en raison du fait qu'il existe un grand nombre de versions de ces composants, qui se différencient les uns des autres par la valeur du courant de défaut, du genre courant de foudre, qu'ils permettent d'écouler, ce qui permet à l'utilisateur de choisir le composant adapté à son application.

Ainsi, les varistances utilisées dans les dispositifs de protection contre les surtensions sont raccordées entre la phase de l'installation électrique à protéger et la terre, et sont conçues de telle sorte qu'en fonctionnement normal, leur impédance est si élevée qu'elles ne créent pas de court-circuit. Au contraire, si une surtension se produit au sein de l'installation, les varistances deviennent passantes et écoulent un courant de défaut, par exemple un courant de foudre, vers la terre, ce qui a pour effet direct d'écrêter la surtension.

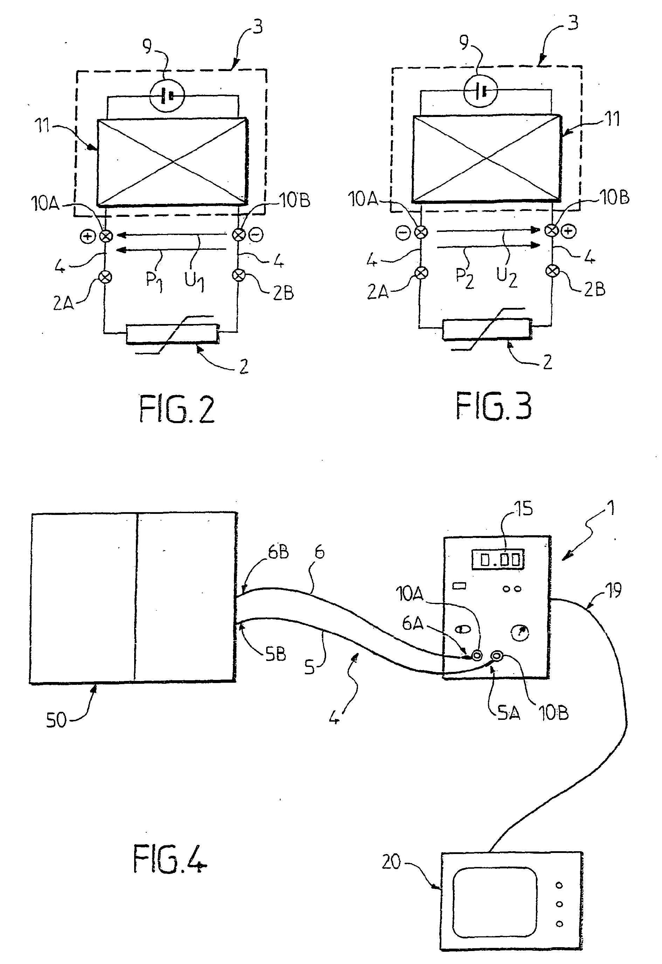

Selon l'invention, l'appareil 1 de contrôle du vieillissement d'une varistance comporte des moyens de génération de tension 3 représentés de façon schématique et simplifiée sur les figures 2 et 3.

Les moyens de génération de tension 3 sont avantageusement agencés pour générer une première tension U₁ présentant une première polarité P₁, et une deuxième tension U₂, préférentiellement de valeur absolue égale ou sensiblement égale à ladite première tension U₁, ladite deuxième tension U₂ présentant une polarité P₂ opposée à ladite première polarité P₁.

L'application de la première tension U₁ et de la deuxième tension U₂ aux bornes 2A, 2B de la varistance 2 permet ainsi de mesurer la résistance et/ou l'intensité du courant traversant la varistance sous deux polarités P₁, P₂ opposées, ce qui permet de contrôler le degré de vieillissement de la varistance.

Selon l'invention, l'appareil 1 de contrôle comporte égaiement des moyens de connexion 4 électrique desdits moyens de génération de tension 3 aux bornes 2A, 2B de la varistance 2.

Selon une variante de l'invention, et tel que cela est représenté sur la figure 4, les moyens de connexion 4 sont formés par au moins deux fils 5, 6 terminés par des extrémités 5A, 5B, 6A, 6B permettant une connexion électrique par contact.

De façon particulièrement avantageuse, les extrémités 5A, 5B, 6A, 6B sont formées par des extrémités proximales 5A, 6A destinées à être connectées à l'appareil 1 de contrôle, et des extrémités distales 5B, 6B destinées à être connectées aux bornes 2A, 2B de la varistance 2 à contrôler.

Avantageusement, les extrémités distales 5B, 6B pourront être de type pointes de touche, et pourront également comporter des moyens mécaniques d'accrochage se présentant par exemple sous la forme de pinces « *crocodile »* ou de pointes « *gripfils ».*

L'appareil 1 de contrôle peut être utilisé pour contrôler directement la varistance mais il peut bien évidemment également être utilisé pour contrôler une cartouche 7 de protection d'installations contre les surtensions, ladite cartouche 7 comprenant au moins une varistance 2 et étant pourvue de moyens de raccordement 8 électrique (figure 1). Dans ce cas, les extrémités distales 5B, 6B des fils 5, 6 viennent directement au contact des moyens de raccordement 8 de la cartouche 7.

Avantageusement, les moyens de génération de tension 3 comportent une source de tension 9 susceptible de générer une tension entre au moins deux pôles 10A, 10B de l'appareil 1 de contrôle à savoir un premier pôle 10A et un deuxième pôle 10B (figures 2 et 3).

De façon particulièrement avantageuse, la source de tension 9 peut comprendre une pile ou une batterie, mais il est également envisageable de brancher l'appareil 1 de contrôle sur le secteur, auquel cas la source de tension 9 comporte de préférence un transformateur.

Selon un premier mode de réalisation de l'invention, les moyens de génération de tension 3 comportent également des moyens d'inversion 11 de la polarité de la tension générée entre les pôles 10A, 10B (figures 2 et 3).

A titre d'exemple illustratif et non limitatif, et tel que cela est représenté sur la figure 2, si le premier pôle 10A est initialement dans un état de plus haut potentiel, alors que le deuxième pôle 10B est dans un état de plus bas potentiel, les moyens d'inversion 11 de la polarité permettent de faire passer le premier pôle 10A dans un état de plus bas potentiel et le deuxième pôle 10B dans un état de plus haut potentiel, tel que cela est représenté sur la figure 3.

Avantageusement, les moyens d'inversion 11 de la polarité sont formés par un déclencheur manuel 12 ou automatique.

Ainsi, à titre d'exemple illustratif, le déclencheur manuel 12 peut comporter un bouton susceptible de prendre deux positions, à savoir une première position 12A associée à la première polarité P₁ et une deuxième position 12B associée à la deuxième polarité P₂. De cette façon, la manipulation du bouton du déclencheur manuel 12 permet d'inverser manuellement et à volonté la polarité de la tension générée entre les pôles 10A, 10B de l'appareil 1 de contrôle (figure 1).

Bien évidemment, les moyens d'inversion 11 de la polarité peuvent être également formés par un déclencheur automatique intégré au sein d'un circuit électronique. Un tel déclencheur automatique permet en particulier de faire effectuer à l'appareil 1 une série de tests de contrôle en limitant le nombre de manipulations de l'utilisateur.

Selon un autre mode réalisation de l'invention, non représenté aux figures, l'appareil 1 de contrôle comprend deux paires de pôles, à savoir une première paire de pôles et une deuxième paire de pôles. Dans ce cas, la première tension U₁ est générée entre les pôles formant la première paire de pôles, et la deuxième tension U₂, de valeur absolue égale mais de polarité P₂ opposée à la polarité P₁ de la première tension U₁, est générée entre les pôles formant la deuxième paire de pôles. Selon ce mode de réalisation, le déclencheur manuel 12 ou automatique n'est plus indispensable, puisqu'il suffit, pour contrôler le degré de vieillissement d'une varistance 2, de connecter successivement les bornes 2A, 2B de cette dernière à la première paire de pôles puis à la deuxième paire de pôles, la connexion pouvant être réalisée à l'aide des moyens de connexion 4.

Avantageusement, l'appareil 1 de contrôle comporte des moyens de mesure (non représentés) d'une première valeur de la résistance de la varistance et/ou de l'intensité du courant passant à travers ladite varistance lorsque la première tension U₁ est appliquée aux bornes 2A, 2B de cette dernière, et d'une deuxième valeur de la résistance de la varistance et/ou de l'intensité du courant passant à travers ladite varistance lorsque la deuxième tension U₂ est appliquée audites bornes 2A, 2B. Les première et deuxième valeurs forment ainsi respectivement une première valeur mesurée et une deuxième valeur mesurée.

Les moyens de mesure seront de préférence conçus de manière à mesurer l'intensité du courant passant à travers la varistance sous une tension donnée, mais iis pourront bien évidemment être conçus de manière à mesurer la résistance de la varistance, cette dernière mesure étant sensiblement équivalente et permettant d'aboutir au même diagnostic concernant le vieillissement de la varistance.

Par ailleurs, les moyens de mesure peuvent également être conçus de manière à mesurer à la fois la résistance et l'intensité du courant traversant la varistance, de telle sorte que si l'un des composants requis pour l'une des mesures, par exemple la mesure de la résistance, est défaillant, il soit possible d'effectuer une seconde mesure de contrôle, visant à mesurer, dans l'exemple présent, l'intensité du courant. Une telle conception peut également permettre une amélioration de la précision des mesures.

De façon particulièrement avantageuse, les moyens de mesure sont de préférence formés par un ohmmètre et/ou un ampèremètre, chacun de ces instruments étant préférentiellement du type classique comprenant par exemple un galvanomètre.

Avantageusement, l'appareil 1 de contrôle comporte une unité de traitement électronique comprenant un microprocesseur connecté à une carte électronique, ledit microprocesseur étant relié fonctionnellement aux moyens de mesure.

L'unité de traitement électronique est de préférence conçue et agencée de manière à stocker la première valeur mesurée, à la comparer à la deuxième valeur mesurée et à calculer une valeur d'écart calculée correspondant à la valeur de l'écart entre la première valeur mesurée et la deuxième valeur mesurée. Ainsi, la caractéristique courant-tension de la varistance n'étant modifiée que dans la polarité d'utilisation de cette dernière, à savoir dans le sens de la phase à protéger vers la terre, la comparaison de la première valeur mesurée, selon la première polarité, à la valeur deuxième mesurée, selon la deuxième polarité, permet de déterminer le degré de vieillissement de la varistance. En effet, les chocs de courant ne sont susceptibles de modifier la caractéristique courant-tension d'une varistance dégradée que dans sa polarité de fonctionnement, de telle sorte que la caractéristique courant-tension dans la polarité opposée à la polarité de fonctionnement est identique à la caractéristique courant-tension de la même varistance à l'état neuf.

Avantageusement, l'appareil 1 de contrôle comprend au moins un moyen de visualisation des informations issues des mesures effectuées par les moyens de mesure. Le moyen de visualisation est de préférence relié fonctionnellement à l'unité de traitement électronique, de façon à afficher la première valeur mesurée, et/ou la deuxième valeur mesurée, et/ou la valeur d'écart calculée. Le moyen de visualisation est également susceptible d'afficher des valeurs déduites des valeurs calculées ou mesurées par le biais d'opérations de calcul supplémentaires.

De façon particulièrement avantageuse, le moyen de visualisation comprend un écran digital 15 susceptible d'afficher, de manière simultanée ou différée, la première valeur mesurée et/ou la deuxième valeur mesurée et/ou la valeur d'écart calculée.

De façon avantageuse, le moyen de visualisation comprend des boutons 16A, 16B lumineux reliés fonctionnellement à l'unité de traitement électronique pour indiquer le degré de vieillissement de la varistance. A titre d'exemple illustratif et non limitatif, les boutons 16A, 16B peuvent être formés par deux voyants à savoir un voyant susceptible, lorsqu'il est allumé, de produire une première lumière, par exemple de couleur verte, signifiant que la varistance peut continuer à être utilisée de façon fiable, et par un voyant apte, lorsqu'il est allumé, à produire une seconde lumière, par exemple de couleur rouge, signifiant que la varistance est dégradée et qu'elle doit être remplacée.

De tels boutons 16A, 16B lumineux peuvent être réalisés à l'aide de diodes électroluminescentes.

On peut également envisager, à la place ou en complément de la visualisation binaire précitée, la possibilité d'une visualisation graduée et progressive de l'état de la varistance, par exemple à l'aide d'une série de diodes aptes à former un dégradé de couleurs, par exemple du vert au rouge en passant par l'orange. Un cadran à aiguilles peut être utilisé, à titre alternatif, pour remplir la même fonction que la série de diodes susmentionnée. Enfin, on peut également prévoir l'affichage d'une marge de sécurité, exprimée par exemple en pourcentages (100% correspondrait à une varistance neuve, tandis que 0% correspondrait à une varistance devant être remplacée).

Avantageusement, l'appareil 1 de contrôle selon l'invention comprend un moyen de visualisation externe relié fonctionnellement à l'unité de traitement électronique par liaison filaire ou hertzienne de préférence, de façon à permettre une lecture déportée des résultats, en particulier des première et deuxième valeurs mesurées, ainsi que de la valeur d'écart calculée.

De façon particulièrement avantageuse, l'appareil 1 de contrôle comprend une première unité de mémoire permettant de stocker une valeur seuil prédéterminée, la valeur seuil étant destinée à être comparée, au sein de l'unité de traitement électronique, à la valeur d'écart calculée. La valeur seuil quantifie l'écart maximal admissible entre la caractéristique courant-tension de la varistance à l'état neuf, et la caractéristique courant-tension de la même varistance après une certaine durée de fonctionnement. En particulier, dès lors que la valeur d'écart calculée dépasse cette valeur seuil, l'appareil 1 de contrôle doit indiquer, notamment par le biais des boutons 16A, 16B, que la varistance doit être remplacée. Ainsi, avant d'effectuer une mesure, la valeur seuil correspondant à la varistance que l'on souhaite contrôler, ou encore toute la gamme de valeurs seuil relatives à une série de varistances à contrôler, sont de préférence entrées dans l'appareil 1 de contrôle, par exemple à l'aide d'un clavier 18 connectable par liaison filaire ou hertzienne à l'appareil 1 de contrôle. L'unité de traitement électronique permet alors de commander le stockage des données dans la mémoire.

Selon une autre variante de l'invention, l'appareil 1 de contrôle comprend une deuxième unité de mémoire reliée fonctionnellement à l'unité de traitement électronique de façon à stocker les valeurs d'écart calculées. Cette deuxième unité de mémoire est de préférence une mémoire de sauvegarde, de type non volatile.

Selon cette variante, l'appareil 1 de contrôle comprend avantageusement une horloge temps réel délivrant un signal représentant la date et l'heure instantanées, et stockant au moins une date et une heure prédéterminées. L'horloge temps réel est de préférence reliée fonctionnellement à l'unité de traitement électronique de telle sorte que la fréquence des séquences d'enregistrement et de stockage au sein de la deuxième unité de mémoire puisse être programmée à l'avance. L'unité de traitement électronique compare alors la date et l'heure instantanées à la date et l'heure prédéterminées, et, si elles sont égales deux à deux, procède au stockage horodaté, dans la deuxième unité de mémoire, des valeurs d'écart calculées à cet instant.

De façon particulièrement avantageuse, la première et la deuxième unités de mémoire peuvent être regroupées au sein d'un unique bloc mémoire du type non volatile.

Selon un autre mode de réalisation de l'invention, l'appareil 1 de contrôle comprend un connecteur de sortie 19 relié fonctionnellement à l'unité de traitement électronique. Le connecteur de sortie 19 est destiné à permettre la connexion de i'appareil 1 de contrôle à un lecteur informatique 20 du genre ordinateur, en vue d'exporter vers celui-ci les valeurs d'écart calculées horodatées contenues dans la deuxième unité de mémoire. Telle que cela est représenté sur la figure 4, le connecteur de sortie 19 se présente de préférence sous la forme d'un câble.

Selon cette variante de réalisation, le traitement des informations, en particulier la comparaison entre les valeurs d'écart calculées et la valeur seuil, peut être effectué par le lecteur informatique 20. Dans ce cas, les valeurs seuil correspondant à la série de varistances que l'on souhaite contrôler seront de préférence enregistrées comme données d'entrée dans le lecteur informatique 20, ou directement dans l'appareil 1.

De façon particulièrement avantageuse, les moyens de génération de tension 3 permettent de générer une tension variable dont l'amplitude peut être sélectionnée à l'aide d'un moyen de réglage 21, par exemple un potentiomètre. Ainsi, la tension à appliquer pour contrôler le degré de vieillissement d'une varistance pourra être choisie en fonction du type de varistance.

En particulier, dans le cas où les caractéristiques (valeur de tension à appliquer et valeur seuil) de chaque type de varistance disponible sur le marché sont stockées dans la mémoire de l'appareil 1, l'utilisateur n'aura plus qu'à sélectionner, au moment du contrôle, le type de varistance à contrôler, à l'aide de tout système de sélection approprié (menu déroulant informatique, potentiomètre, clavier, etc.).

Selon une autre variante de l'invention, et tel que cela est représenté sur la figure 1, l'appareil 1 comporte une embase 24 intégrant les moyens de connexion 4. L'embase 24 est de préférence reliée fonctionnellement, en particulier électriquement aux moyens de mesure. L'embase 24 est par ailleurs agencée pour recevoir de façon amovible, en vue de la contrôler, une cartouche 7 de protection d'installations contre les surtensions, la cartouche 7 comprenant au moins une varistance et étant pourvue de moyens de raccordement 8 électrique. De telles cartouches 7, en tant que telles, sont bien connues de l'homme du métier.

De façon préférentielle, la cartouche 7 est généralement de forme parallélépipédique et les moyens de raccordement 8 électrique sont préférentiellement de type mâle. Ainsi, les moyens de raccordement 8 électrique se présentent de préférence sous la forme d'au moins deux broches 8A, 8B permettant la connexion de la cartouche 7 à l'installation électrique.

Bien évidemment, la configuration à deux broches 8A, 8B illustrée sur la figure 1 n'est donnée qu'à titre illustratif, mais n'est absolument pas limitative. La cartouche 7 peut en effet comporter par exemple quatre broches de connexion électrique ou se présenter sous une toute autre forme.

Avantageusement, l'embase 24 comporte un logement 25 susceptible de recevoir ladite cartouche 7. A cet effet, la section transversale du logement 25 correspond sensiblement à la section transversale de la cartouche 7 de telle sorte que cette dernière puisse être introduite dans le logement 25 avec un jeu faible.

En particulier, la cartouche 7 est destinée à être enfichée sur l'embase 24. A cet effet, le logement 25 est de préférence pourvu de moyens de contact électrique complémentaires des moyens de raccordement 8 de la cartouche 7. Les moyens de contact électrique forment alors les moyens de connexion 4.

De façon particulièrement avantageuse, les moyens de contact électrique sont aménagés au sein de trous 26A, 26B, ménagés de préférence sur le fond 27 du logement 25, lesdits trous 26A, 26B présentant préférentiellement des sections rectangulaires, sensiblement complémentaires de celles des broches 8A, 8B.

Bien évidemment, le nombre de trous 26A, 26B ménagés sur le fond 27 sera de préférence égal au nombre de broches 8A, 8B de la cartouche 7. Les trous 26A, 26B forment ainsi les moyens femelles de connexion complémentaires des moyens mâles formés par les broches 8A, 8B.

De façon particulièrement avantageuse, la cartouche 7 est enfichée sur l'embase 24 à l'aide de moyens de guidage en translation, tels que des gorges 29, 30 ménagées sur les bords latéraux du logement 25. Les gorges 29, 30 permettent également d'empêcher sensiblement le mouvement de la cartouche 7 après son introduction au sein du logement 25.

L'appareil 1 de contrôle comprend également, de façon préférentielle, des moyens mécaniques de fixation de la cartouche 7 au sein du logement 25. Ces moyens mécaniques peuvent par exemple comporter au moins un ergot et un orifice correspondant, ces derniers pouvant être ménagés respectivement sur la cartouche 7 et sur l'embase 24, ou inversement. Bien évidemment, cette configuration des moyens de fixation n'est pas limitative et l'appareil pourra comporter d'autres moyens de fixation mécaniques adaptés aux cartouches 7 disponibles sur le marché et bien connues de l'homme du métier.

Avantageusement, l'appareil 1 de contrôle comporte un boîtier 40 portatif, au sein duquel sont agencés les moyens de génération de tension 3, les moyens de mesure, l'unité de traitement électronique et le moyen de visualisation. Tel que cela est représenté sur la figure 1, l'écran digital 15, le moyen de réglage 21, les boutons 16A, 16B, le déclencheur manuel 12 ainsi que les pôles 10A, 10B sont de préférence situés sur la face frontale 40A du boîtier 40. En outre, le logement 25 est de préférence ménagé vers l'extrémité du boîtier opposée à l'écran digital 15, mais cette configuration n'est pas limitative et il est par exemple envisageable de ménager le logement 25 sur la face frontale 40A du boîtier 40.

Bien évidemment, les trous 26A, 26B de réception des broches 8A, 8B peuvent être directement ménagés sur une des faces du boîtier 40, auquel cas il n'est pas nécessaire de réaliser un logement 25 de réception de la cartouche 7.

De façon particulièrement avantageuse, le boîtier 40 peut se présenter sous une forme miniaturisée, par exemple sous la forme d'un module susceptible d'être enfiché sur un tableau électrique ou directement sur l'installation pourvue du dispositif de protection contre les surtensions. Le vieillissement de la varistance pourra alors être contrôlé à distance, notamment à l'aide du moyen de visualisation externe et/ou du lecteur informatique 20, de telle sorte qu'il ne sera pas nécessaire de dépêcher un technicien sur place pour contrôler le degré de vieillissement de la varistance.

L'utilisation et le fonctionnement de l'appareil 1 de contrôle du vieillissement d'une varistance vont maintenant être décrits.

Le contrôle du vieillissement d'une varistance utilisée dans le cadre d'un dispositif de protection d'une installation contre les surtensions peut être effectué sur place ou à distance.

Dans le cas où le contrôle est effectué sur place, par exemple par un technicien chargé de la maintenance de l'installation électrique, les valeurs seuil représentatives de l'écart entre la caractéristique courant-tension des varistances à l'état neuf et la caractéristique courant-tension des varistances dégradées, sont préalablement enregistrées en tant que données d'entrée dans l'appareil 1 de contrôle, par exemple à l'aide du clavier 18. Les valeurs seuil correspondent à un type de varistance donné, et l'on pourra par exemple enregistrer toute une gamme de valeurs seuil correspondant à une série de varistances, auquel cas, le technicien devra sélectionner, avant chaque mesure, la valeur seuil correspondant à la varistance à contrôler.

Si le dispositif de protection contre les surtensions se présente sous la forme d'une simple varistance intégrée à l'installation électrique à protéger, l'appareil 1 de contrôle sera de préférence directement connecté aux bornes 2A, 2B de la varistance 2 à contrôler, par exemple à l'aide de pointes de touche se présentant sous la forme de deux fils 5, 6 pourvus d'extrémités proximales 5A, 6A destinées à être enfichées dans les pôles 10A, 10B de l'appareil 1 et d'extrémités distales 58, 6B destinées être à connectées directement aux bornes 2A, 2B de la varistance 2.

Si l'appareil 1 de contrôle comporte deux paires de pôles, la varistance peut successivement être connectée, par l'intermédiaire des moyens de connexion 4, à chacune des paires de pôles de l'appareil 1 de manière à ce que sa résistance, et/ou l'intensité du courant la traversant sous une tension de même valeur absolue, soit (soient) mesurée(s) successivement suivant deux polarités opposées.

Si l'appareil 1 de contrôle ne comporte que deux pôles 10A, 10B, les bornes 2A, 2B de la varistance 2 sont de préférence connectées à ces deux pôles, et il suffit au technicien, pour effectuer la mesure de contrôle, d'inverser la polarité de la tension générée entre les pôles 10A, 10B, par exemple à l'aide d'un déclencheur manuel 12. Bien évidemment, l'appareil 1 de contrôle peut être également pourvu d'un déclencheur automatique, de telle sorte que l'appareil 1 effectue systématiquement, et sans commande extérieure, une série de tests de contrôle.

La tension à appliquer aux bornes 2A, 2B de la varistance 2 à contrôler peut être sélectionnée de préférence avant la mesure, par exemple à l'aide d'un potentiomètre monté sur le boîtier 40 de l'appareil 1 de contrôle. Après chaque mesure, les différents résultats sont affichés successivement ou simultanément grâce à un moyen de visualisation, par exemple un écran digital 15, sur lequel apparaissent les première et deuxième valeurs mesurées, ainsi que la valeur d'écart calculée et éventuellement la valeur seuil caractéristique de la varistance à contrôler.

De façon particulièrement avantageuse, l'appareil 1 de contrôle indique également, par exemple à l'aide des boutons 16A, 16B lumineux, si la varistance doit ou non être remplacée. En particulier, l'appareil 1 peut indiquer, par exemple à l'aide d'un voyant vert, que la varistance contrôlée peut encore être utilisée pour protéger l'installation. A l'inverse si la marge restant avant la fin de vie de la varistance est trop faible, en d'autres termes si le risque de défaillance de la varistance avant le prochain contrôle est trop grand, l'appareil 1 de contrôle peut indiquer, par exemple à l'aide d'un voyant rouge, qu'il est nécessaire de remplacer la varistance. De cette façon, le technicien chargé du contrôle n'a aucune opération de calcul à effectuer, et le résultat des tests peut être lu directement sur l'appareil 1 de contrôle.

Bien évidemment, il est envisageable de réaliser un appareil 1 de contrôle simplifié, qui se limite par exemple à mesurer la résistance et/ou l'intensité du courant traversant la varistance sous une première tension U₁ puis une deuxième tension U₂, les première et deuxième tensions présentant des polarités P₁, P₂ opposées, auquel cas le technicien chargé du contrôle doit effectuer lui-même le calcul de la différence entre les première et deuxième valeurs mesurées et comparer la valeur de la différence, c'est-à-dire la valeur d'écart calculée, avec la valeur seuil propre à la varistance contrôlée.

Si l'installation est pourvue d'un dispositif de protection contre les surtensions comportant une cartouche 7 amovible, il suffit au technicien de déconnecter cette cartouche 7 de l'installation électrique et de l'enficher sur l'appareil 1 de contrôle de manière à effectuer les tests de contrôle. En particulier, la cartouche 7 peut être introduite dans le logement 25 ménagé à cet effet dans l'embase 24 de l'appareil 1 de contrôle de telle sorte que les broches 8A, 8B de connexion de la cartouche 7 pénètrent à l'intérieur des trous 26A, 26B correspondants ménagés sur l'embase 24.

Il est bien évidemment envisageable d'utiliser d'autres moyens de connexion 4, et en particulier des fils 5, 6 pour connecter l'appareil 1 de contrôle à la cartouche 7. Les fils 5, 6 pourront alors être pourvus, à l'une au moins de leurs extrémités, de pointes de touche ou, encore plus préférentiellement, de pinces « *crocodile* ».

Selon une autre variante de fonctionnement de l'appareil, le contrôle du vieillissement d'une varistance peut également s'effectuer à distance, l'appareil 1 de contrôle étant alors connecté de façon sensiblement permanente aux bornes 2A, 2B de la varistance 2 ou encore aux moyens de raccordement 8 électrique de la cartouche 7, la varistance 2 ou la cartouche 7 étant intégrée au sein d'une l'installation 50 à protéger. Dans ce cas, la lecture des résultats du contrôle peut être effectuée à distance, par exemple à l'aide d'un moyen de visualisation externe ou encore d'un lecteur informatique 20. La fréquence des contrôles est alors pré-programmée, de telle sorte qu'il n'est pas nécessaire d'intervenir sur l'installation pour vérifier la fiabilité de la varistance.

L'appareil de contrôle du vieillissement d'une varistance selon l'invention permet donc d'éliminer le risque de défaillance des varistances montées sur des installations électriques.

Un autre avantage de l'appareil de contrôle selon l'invention est qu'il permet de contrôler le degré de vieillissement des varistances sans qu'il soit nécessaire de démonter, même partiellement, l'installation électrique, notamment pour retirer le composant en vue de le contrôler.

Un autre avantage de l'appareil de contrôle selon l'invention est qu'il ne provoque aucune perturbation de l'installation électrique.

L'invention concerne également un procédé de contrôle du vieillissement d'une varistance 2 comportant une étape (a) de mesure d'une première valeur de la résistance de ladite varistance 2 et/ou de l'intensité du courant la traversant lorsqu'une première tension U₁ est appliquée aux bornes 2A, 2B de la varistance 2 selon une première polarité P₁, ladite première valeur formant une première valeur mesurée.

Selon l'invention, le procédé comprend également une étape (b) de mesure d'une deuxième valeur de la résistance de la varistance 2 et/ou de l'intensité du courant la traversant lorsqu'une deuxième tension U₂, de valeur absolue préférentiellement sensiblement égale à celle de la première tension U₁, est appliquée aux bornes 2A, 2B de la varistance 2 selon une deuxième polarité P₂.

Au sens de l'invention, la deuxième polarité P₂ est opposée à la première polarité P₁, et la deuxième valeur de la résistance et/ou de l'intensité du courant la traversant forme une deuxième valeur mesurée.

Selon l'invention, le procédé comprend également une étape (c), postérieure aux étapes (a) et (b), de comparaison des première et deuxième valeurs mesurées.

Au sens de l'invention, il est tout à fait équivalent de mesurer la résistance de la varistance ou l'intensité du courant traversant la varistance lorsqu'une même tension est appliquée aux bornes de la varistance. Il s'agit en effet de comparer la résistance ou encore l'intensité du courant traversant la varistance entre un premier état, correspondant à l'application d'une première tension U₁ présentant une première polarité P₁, aux bornes 2A, 2B de la varistance 2 (figure 2), et un deuxième état, correspondant à l'application d'une deuxième tension U₂ présentant une polarité P₂ opposée à la première polarité P₁, entre les bornes 2A, 2B de la varistance 2 (figure 3).

Avantageusement, le procédé comporte une étape (d), postérieure aux étapes (a) et (b), de calcul d'une valeur d'écart calculée correspondant à l'écart, par exemple la différence, entre les première et deuxième valeurs mesurées. Il est bien évidemment possible d'effectuer une autre opération qu'une différence entre les première et deuxième valeurs mesurées pour obtenir la valeur d'écart calculée. En particulier, ladite valeur d'écart calculée pourra correspondre au résultat d'une division entre la première et la deuxième valeurs mesurées.

De façon particulièrement avantageuse, le procédé selon l'invention comporte une étape (e) d'affichage de la première valeur mesurée, et/ou de la deuxième valeur mesurée et/ou de la valeur d'écart calculée. Les première et deuxième valeurs mesurées, ainsi que la valeur d'écart calculée peuvent être affichées de manière simultanée ou bien l'une après l'autre, sur commande de l'utilisateur ou bien de façon automatique dans le cadre d'une série de tests pré-programmés.

Avantageusement, le procédé selon l'invention comporte une étape (f) de comparaison entre la valeur d'écart calculée et une valeur seuil prédéterminée et stockée, la valeur seuil définissant la limite que la valeur d'écart calculée ne doit pas dépasser pour que la varistance puisse être considérée comme fiable. Si la valeur d'écart calculée est supérieure à la valeur seuil prédéterminée, la varistance doit de préférence être remplacée.

Selon une autre variante du procédé, la détermination des première et deuxième valeurs ainsi que de la valeur d'écart calculée est utilisée pour assurer le suivi du vieillissement d'une varistance montée sur une installation électrique.

Selon cette variante, le procédé comprend une étape (g) de stockage horodaté, dans une mémoire de préférence non volatile, des première et deuxième valeurs mesurées ainsi que de la valeur d'écart calculée. Le cycle d'acquisition constitué par les étapes (a) à (g) est de préférence répété de façon périodique selon une fréquence dite d'acquisition prédéterminée.

Avantageusement, le procédé comprend également une étape (h) d'exportation des informations horodatées contenues dans la mémoire vers un lecteur informatique 20, l'étape (h) étant réalisée de façon périodique selon une fréquence dite de récupération supérieure ou égale à la fréquence d'acquisition.

De façon particulièrement avantageuse, le procédé comprend une étape (i) de traitement des informations horodatées exportées à l'aide d'un programme informatique, de façon à obtenir des informations de suivi dans le temps du vieillissement de la varistance. Bien évidemment, la valeur seuil peut constituer :
- soit une donnée d'entrée de l'unité de traitement électronique, cette donnée étant préalablement enregistrée dans l'appareil 1 de contrôle, et pouvant ensuite être exportée de la même façon que les informations horodatées contenues dans la mémoire,
- soit une donnée d'entrée d'un programme informatique de traitement des informations horodatées exportées vers le lecteur informatique 20.

Le procédé de contrôle du vieillissement d'une varistance selon l'invention permet donc d'évaluer de façon simple et efficace le degré de vieillissement d'une varistance, sans qu'il soit nécessaire de connaître et de mesurer la caractéristique courant-tension de la varistance à l'état neuf.

Un autre avantage du procédé selon l'invention est qu'il permet de suivre l'évolution de la dégradation d'une varistance, et de prévenir sa destruction, de telle sorte que l'installation électrique soit toujours protégée de manière optimale.

Un autre avantage du procédé selon l'invention est qu'il permet de contrôler rapidement un grand nombre de varistances.

## Revendications

1. Appareil de contrôle du vieillissement d'une varistance (2) par application d'une tension entre les bornes (2A, 2B) de ladite varistance (2) comportant :
- des moyens de génération de tension (3), agencés pour générer :
- une première tension (U₁) présentant une première polarité (P₁),
- une deuxième tension (U₂) présentant une deuxième polarité (P₂) opposée à ladite première polarité (P₁),
- des moyens de connexion (4) électrique desdits moyens de génération de tension (3) aux bornes (2A, 2B) de ladite varistance (2),
- des moyens de mesure d'une part d'une première valeur de la résistance de ladite varistance et/ou de l'intensité du courant passant à travers ladite varistance lorsque la première tension (U₁) est appliquée aux bornes (2A, 23) de cette dernière, et d'autre part d'une deuxième valeur de la résistance de ladite varistance et/ou de l'intensité du courant passant à travers ladite varistance lorsque la deuxième tension (U₂) est appliquée audites bornes (2A, 2B), lesdites première et deuxième valeurs formant une première valeur mesurée et une deuxième valeur mesurée,
- et une unité de traitement électronique agencée de manière à stocker ladite première valeur mesurée, à la comparer à ladite deuxième valeur mesurée et à calculer une valeur d'écart calculée correspondant à la valeur de l'écart entre ladite première valeur mesurée et ladite deuxième valeur mesurée.

2. Appareil selon la revendication 1 **caractérisé en ce que** les moyens de génération de tension (3) comportent :
- une source de tension (9), susceptible de générer une tension entre au moins deux pôles (10A, 10B) dudit appareil (1),
- des moyens d'inversion (11) de la polarité de ladite tension entre lesdits au moins deux pôles (10A, 10B).

3. Appareil selon la revendication 1 **caractérisé en ce qu'**il comporte :
- une première paire de pôles, ladite première tension (U₁) étant générée entre lesdits pôles formant ladite première paire de pôles,
- une deuxième paire de pôles, ladite deuxième tension (U₂) étant générée entre lesdits pôles formant ladite deuxième paire de pôles.

4. Appareil selon l'une des revendications 1 à 3 **caractérisé en ce que** lesdits moyens de mesure sont formés par un ohmmètre et/ou un ampèremètre.

5. Appareil selon l'une des revendications 1 à 4 **caractérisé en ce qu'**il comprend au moins un moyen de visualisation des informations issues des mesures effectuées par lesdits moyens de mesure, ledit moyen de visualisation étant relié fonctionnellement à ladite unité de traitement électronique, de façon à afficher ladite première valeur mesurée et/ou ladite deuxième valeur mesurée et/ou ladite valeur d'écart calculée

6. Appareil selon la revendication 5 **caractérisé en ce que** le moyen de visualisation comprend des boutons (16A, 16B) lumineux reliés fonctionnellement à l'unité de traitement électronique pour indiquer le degré de vieillissement de la varistance.

7. Appareil selon l'une des revendications 1 à 6 **caractérisé en ce qu'**il comprend un moyen de visualisation externe relié fonctionnellement à ladite unité de traitement électronique de façon à permettre une lecture déportée des résultats.

8. Appareil selon l'une des revendications 1 à 7 **caractérisé en ce qu'**il comprend une première unité de mémoire permettant de stocker une valeur seuil prédéterminée, ladite valeur seuil étant destinée à être comparée, au sein de l'unité de traitement électronique, aux valeurs d'écart calculées.

9. Appareil selon l'une des revendications 1 à 8 **caractérisé en ce qu'**il comprend une deuxième unité de mémoire reliée fonctionnellement à l'unité de traitement électronique de façon à stocker les valeurs d'écart calculées.

10. Appareil selon la revendication 9 **caractérisé en ce qu'**il comprend une horloge temps réel délivrant un signal représentant la date et l'heure instantanées, et stockant au moins une date et une heure prédéterminées, ladite horloge temps réel étant reliée fonctionnellement à l'unité de traitement électronique pour que cette dernière compare la date et l'heure instantanées à la date et l'heure prédéterminées, et si elles sont égales deux à deux, procède au stockage horodaté dans la deuxième unité de mémoire des valeurs d'écart calculées à cet instant.

11. Appareil selon la revendication 9 ou 10 **caractérisé en ce qu'**il comprend un connecteur de sortie (19) relié fonctionnellement à l'unité de traitement électronique, de manière à pouvoir connecter l'appareil (1) à un lecteur informatique (20) du genre ordinateur, en vue d'exporter vers celui-ci les valeurs d'écart calculées horodatées contenues dans la deuxième unité de mémoire.

12. Appareil selon l'une quelconque des revendications 1 à 11 **caractérisé en ce que** les moyens de génération de tension (3) permettent de générer une tension variable dont l'amplitude peut être sélectionnée à l'aide d'un moyen de réglage (21), du genre potentiomètre.

13. Appareil selon l'une quelconque des revendications 1 à 12 **caractérisé en ce que** les moyens de connexion (4) électrique sont formés par au moins deux fils (5, 6), terminés par des extrémités (5A, 5B, 6A, 6B) permettant une connexion électrique par contact.

14. Appareil selon l'une quelconque des revendications 1 à 13 **caractérisé en ce qu'**il comporte une embase (24) intégrant lesdits moyens de connexion (4), ladite embase étant reliée fonctionnellement aux moyens de mesure, et étant agencée pour recevoir de façon amovible, en vue de la contrôler, une cartouche (7) de protection d'installations contre les surtensions, ladite cartouche (7) comprenant au moins une varistance et étant pourvue de moyens de raccordement (8) électrique.

15. Appareil selon la revendication 14 **caractérisé en ce que** l'embase (24) comporte un logement (25) susceptible de recevoir ladite cartouche (7), ledit logement étant pourvu de moyens de contact électrique complémentaires desdits moyens de raccordement (8) de la cartouche (7), lesdits moyens de contact électrique formant lesdits moyens de connexion (4).

16. Appareil selon la revendication 5 **caractérisé en ce qu'**il comporte un boîtier (40) portatif au sein duquel sont agencés les moyens de génération de tension (3), les moyens de mesure, l'unité de traitement électronique et le moyen de visualisation.

17. Procédé de contrôle du vieillissement d'une varistance (2) par application d'une tension entre les bornes (2A, 2B) de ladite varistance (2), ledit procédé comportant :
- une étape (a) de mesure d'une première valeur de la résistance de ladite varistance (2) et/ou de l'intensité du courant la traversant lorsqu'une première tension (U₁) est appliquée aux bornes (2A, 2B) de la varistance (2) selon une première polarité (P₁), ladite première valeur formant une première valeur mesurée,
- une étape (b) de mesure d'une deuxième valeur de la résistance de ladite varistance (2) et/ou de l'intensité du courant la traversant lorsqu'une deuxième tension (U₂) est appliquée aux bornes (2A, 2B) de la varistance (2) selon une deuxième polarité (P₂), ladite deuxième polarité (P₂) étant opposée à ladite première polarité (P₁), et ladite deuxième valeur formant une deuxième valeur mesurée,
- puis une étape (c) de comparaison desdites première et deuxième valeurs mesurées.

18. Procédé selon la revendication 17 **caractérisé en ce que** la deuxième tension (U₂) possède une valeur absolue égale à celle de la première tension (U₁).

19. Procédé selon la revendication 17 ou 18 **caractérisé en ce qu'**il comporte une étape (d) de calcul d'une valeur d'écart calculée correspondant à l'écart entre lesdites première et deuxième valeurs mesurées.

20. Procédé selon la revendication 19 **caractérisé en ce qu'**il comporte une étape (e) d'affichage de ladite première valeur mesurée et/ou de ladite deuxième valeur mesurée et/ou de ladite valeur d'écart calculée.

21. Procédé selon la revendication 19 ou 20 **caractérisé en ce qu'**il comporte une étape (f) de comparaison entre ladite valeur d'écart calculée, et une valeur seuil prédéterminée et stockée.

22. Procédé selon l'une des revendications 19 à 21 **caractérisé en ce que** la détermination desdites première et deuxième valeurs et de ladite valeur d'écart calculée est utilisée pour assurer le suivi du vieillissement d'une varistance (2) montée sur une installation électrique (50).

23. Procédé selon la revendication 22 **caractérisé en ce qu'**il comprend :
- une étape (g) de stockage horodaté dans une mémoire desdites premières et deuxième valeurs mesurées, ainsi que de ladite valeur d'écart calculée, le cycle d'acquisition constitué par les étapes (a) à (g) étant répété de façon périodique selon une fréquence d'acquisition,
- une étape (h) d'exportation des informations horodatées contenues dans la mémoire vers un lecteur informatique (20), cette étape (h) étant réalisée de façon périodique selon une fréquence de récupération supérieure ou égale à la fréquence d'acquisition,
- une étape (i) de traitement des informations horodatées exportées à l'aide d'un programme informatique, de façon à obtenir des informations de suivi dans le temps du vieillissement de la varistance (2).

## Claims

1. Apparatus for checking the aging of a varistor (2) by the application of a voltage between the terminals (2A, 2B) of the said varistor (2), comprising:
- voltage generation means (3), arranged so as to generate:
- a first voltage (U₁) having a first polarity (P₁),
- a second voltage (U₂) having a second polarity (P₂) opposite to the said first polarity (P₁),
- means (4) of electrically connecting the said voltage generation means (3) to the terminals (2A, 2B) of the said varistor (2),
- means of measuring on the one hand a first value of the resistance of the said varistor and/or of the intensity of the current passing through the said varistor when the first voltage (U₁) is applied to the terminals (2A, 2B) of the latter, and on the other hand a second value of the resistance of the said varistor and/or of the intensity of the current passing through the said varistor when the second voltage (U₂) is applied to the said terminals (2A, 2B), the said first and second values forming a first measured value and a second measured value,
- and an electronic processing unit arranged so as to store the said first measured value, to compare it with the said second measured value and to calculate a difference value corresponding to the value of the difference between the said first measured value and the said second measured value.

2. Apparatus according to claim 1, **characterised in that** the voltage generation means (3) comprise:
- a voltage source (9), able to generate a voltage between at least two poles (10A, 10B) of the said apparatus (1),
- means (11) of reversing the polarity of the said voltage between the said at least two poles (10A, 10B).

3. Apparatus according to claim 1, **characterised in that** it comprises:
- a first pair of poles, the said first voltage (U₁) being generated between the said poles forming the said first pair of poles,
- a second pair of poles, the said second voltage (U₂) being generated between the said poles forming the said second pair of poles.

4. Apparatus according to one of claims 1 to 3, **characterised in that** the said measuring means are formed by an ohmmeter and/or an ammeter.

5. Apparatus according to one of claims 1 to 4, **characterised in that** it comprises at least one means of displaying the information issuing from the measurements made by the said measuring means, the said display means being connected functionally to the said electronic processing unit, so as to display the said first measured value and/or the said second measured value and/or the said calculated difference value.

6. Apparatus according to claim 5, **characterised in that** the display means comprises luminous buttons (16A, 16B) functionally connected to the electronic processing unit in order to indicate the degree of aging of the varistor.

7. Apparatus according to one of claims 1 to 6, **characterised in that** it comprises an external display means functionally connected to the said electronic processing unit so as to allow remote reading of the results.

8. Apparatus according to one of claims 1 to 7, **characterised in that** it comprises a first memory unit for storing a predetermined threshold value, the said threshold value being intended to be compared, within the electronic processing unit, with the calculated difference values.

9. Apparatus according to one of claims 1 to 8, **characterised in that** it comprises a second memory unit functionally connected to the electronic processing unit so as to store the calculated difference values.

10. Apparatus according to claim 9, **characterised in that** it comprises a real-time clock delivering a signal representing the instantaneous date and time, and storing at least one predetermined date and time, the said real-time clock being functionally connected to the electronic processing unit so that the latter compares the instantaneous date and time with the predetermined date and time and, if they are equal in pairs, proceeds with the time-dated storage in the second memory unit of the difference values calculated at this moment.

11. Apparatus according to claim 9 or 10, **characterised in that** it comprises an output connector (19) functionally connected to the electronic processing unit, so as to be able to connect the apparatus (1) to a data processing reader (20) of the computer type, with a view to exporting to the latter the time-dated calculated difference values contained in the second memory unit.

12. Apparatus according to one of claims 1 to 11, **characterised in that** the voltage generation means (3) make it possible to generate a variable voltage whose amplitude can be selected using an adjustment means (21) of the potentiometer type.

13. Apparatus according to one of claims 1 to 12, **characterised in that** the electrical connection means (4) are formed by at least two wires (5, 6) terminating in ends (5A, 5B, 6A, 6B) allowing electrical connection by contact.

14. Apparatus according to one of claims 1 to 13, **characterised in that** it comprises a base (24) integrating the said connection means (4), the said base being functionally connected to the measuring means and being arranged so as to receive removably, with a view to checking it, a cartridge (7) for protecting installations against overvoltages, the said cartridge (7) comprising at least one varistor and being provided with electrical connection means (8).

15. Apparatus according to claim 14, **characterised in that** the base (24) comprises a housing (25) able to receive the said cartridge (7), the said housing being provided with electrical contact means complementary to the said connection means (8) of the cartridge (7), the said electrical contact means forming the said connection means (4).

16. Apparatus according to claim 5, **characterised in that** it comprises a portable casing (40) within which there are arranged the voltage generation means (3), the measuring means, the electronic processing unit and the display means.

17. Method of checking the aging of a varistor (2) by applying a voltage between the terminals (2A, 2B) of the said varistor (2), the said method comprising:
- a step (a) of measuring a first value of the resistance of the said varistor (2) and/or of the intensity of the current passing through it when a first voltage (U₁) is applied to the terminals (2A, 2B) of the varistor (2) according to a first polarity (P₁), and the said first value forming a first measured value,
- a step (b) of measuring a second value of the resistance of the said varistor (2) and/or of the intensity of the current passing through it when a second voltage (U₂) is applied to the terminals (2A, 2B) of the varistor (2) according to a second polarity (P₂), the said second polarity (P₂) being opposite to the said first polarity (P₁), and the said second value forming a second measured value,
- then a step (c) of comparing the said first and second measured values.

18. Method according to claim 17, **characterised in that** the second voltage (U₂) has an absolute value equal to that of the first voltage (U₁).

19. Method according to claim 17 or 18, **characterised in that** it comprises a step (d) of calculating a calculated difference value corresponding to the difference between the said first and second measured values.

20. Method according to claim 19, **characterised in that** it comprises a step (e) of displaying the said first measured value and/or the said second measured value and/or the said calculated difference value.

21. Method according to claim 19 or 20, **characterised in that** it comprises a step (f) of comparison between the said calculated difference value and a predetermined stored threshold value.

22. Method according to one of claims 19 to 21, **characterised in that** the determination of the said first and second values and of the said calculated difference value is used to monitor the aging of a varistor (2) mounted on an electrical installation (50).

23. Method according to claim 22, **characterised in that** it comprises:
- a step (g) of time-dated storage of the said first and second measured values in a memory, as well as the said calculated difference value, the acquisition cycle consisting of steps (a) to (g) being repeated periodically according to an acquisition frequency,
- a step (h) of exporting the time-dated information contained in the memory to a data processing reader (20), this step (h) being carried out periodically according to a retrieval frequency greater than or equal to the acquisition frequency,
- a step (i) of processing the time-dated information exported by means of a computer program, so as to obtain information on the monitoring over time of the aging of the varistor (2).

## Patentansprüche

1. Gerät zur Prüfung der Alterung eines Varistors (2) durch Anlegen einer Spannung zwischen den Klemmen (2A, 2B) des Varistors (2), umfassend:
- Mittel zum Erzeugen von Spannung (3), eingerichtet, um Folgendes zu erzeugen:
- eine erste Spannung (U₁), die eine erste Polung (P₁) aufweist,
- eine zweite Spannung (U₂), die eine zweite Polung (P₂) aufweist, die der ersten Polung (P₁) entgegengesetzt ist,
- Mittel zum elektrischen Anschließen (4) der Mittel zum Erzeugen von Spannung (3) an die Klemmen (2A, 2B) des Varistors (2),
- Mittel zum Messen einerseits eines ersten Werts des Widerstands des Varistors und/oder der Stärke des Stroms, der durch den Varistor läuft, wenn die erste Spannung (U₁) an die Klemmen (2A, 2B) dieses Letzteren angelegt wird, und andererseits eines zweiten Werts des Widerstands des Varistors und/oder der Stärke des Stroms, der durch den Varistor läuft, wenn die zweite Spannung (U₂) an die Klemmen (2A, 2B) angelegt wird, wobei der erste und der zweite Wert einen ersten Messwert und einen zweiten Messwert bilden,
- und eine elektronische Verarbeitungseinheit, die eingerichtet ist, um den ersten Messwert zu speichern, ihn mit dem zweiten Messwert zu vergleichen und einen berechneten Unterschiedswert zu berechnen, der dem Wert des Unterschieds zwischen dem ersten Messwert und dem zweiten Messwert entspricht.

2. Gerät nach Anspruch 1, **dadurch gekennzeichnet, dass** die Mittel zum Erzeugen von Spannung (3) Folgendes umfassen:
- eine Spannungsquelle (9), die eine Spannung zwischen mindestens zwei Polen (10A, 10B) des Geräts (1) erzeugen kann,
- Mittel (11) zum Umkehren der Polung der Spannung zwischen den mindestens zwei Polen (10A, 10B).

3. Gerät nach Anspruch 1, **dadurch gekennzeichnet, dass** es Folgendes umfasst:
- ein erstes Paar Pole, wobei die erste Spannung (U₁) zwischen den Polen, die das erste Polpaar bilden, erzeugt wird,
- ein zweites Paar Pole, wobei die zweite Spannung (U₂) zwischen den Polen, die das zweite Polpaar bilden, erzeugt wird.

4. Gerät nach einem der Ansprüche 1 bis 3, **dadurch gekennzeichnet, dass** die Messmittel aus einem Ohmmeter und/oder einem Amperemeter bestehen.

5. Gerät nach einem der Ansprüche 1 bis 4, **dadurch gekennzeichnet, dass** es mindestens ein Mittel zum Anzeigen der Informationen aufweist, die aus den Messungen hervorgehen, die von den Messmitteln durchgeführt werden, wobei das Anzeigemittel funktional mit der elektronischen Verarbeitungseinheit derart verbunden ist, dass der erste Messwert und/oder der zweite Messwert und/oder der berechnete Unterschiedswert angezeigt wird.

6. Gerät nach Anspruch 5, **dadurch gekennzeichnet, dass** das Anzeigemittel Leuchttasten (16A, 16B) aufweist, die funktional mit der elektronischen Verarbeitungseinheit verbunden sind, um den Alterungsgrad des Varistors anzuzeigen.

7. Gerät nach einem der Ansprüche 1 bis 6, **dadurch gekennzeichnet, dass** es ein externes Anzeigemittel umfasst, das funktional mit der elektronischen Verarbeitungseinheit verbunden ist, um ein dezentrales Lesen der Ergebnisse zu erlauben.

8. Gerät nach einem der Ansprüche 1 bis 7, **dadurch gekennzeichnet, dass** es eine erste Speichereinheit aufweist, die es erlaubt, einen vorausbestimmten Schwellenwert zu speichern, wobei der Schwellenwert dazu bestimmt ist, innerhalb der elektronischen Verarbeitungseinheit mit den berechneten Unterschiedswerten verglichen zu werden.

9. Gerät nach einem der Ansprüche 1 bis 8, **dadurch gekennzeichnet, dass** es eine zweite Speichereinheit aufweist, die funktional mit der elektronischen Verarbeitungseinheit verbunden ist, um die berechneten Unterschiedswerte zu speichern.

10. Gerät nach Anspruch 9, **dadurch gekennzeichnet, dass** es einen Echtzeittaktgeber aufweist, der ein Signal liefert, das das augenblickliche Datum und die augenblickliche Uhrzeit darstellt und mindestens ein vorausbestimmtes Datum und eine vorausbestimmte Uhrzeit speichert, wobei der Echtzeittaktgeber funktional mit der elektronischen Verarbeitungseinheit verbunden ist, damit Letztere das augenblickliche Datum und die augenblickliche Uhrzeit mit dem vorausbestimmten Datum und der vorausbestimmten Uhrzeit vergleicht, und, wenn diese jeweils in Paaren gleich sind, das Speichern der in diesem Augenblick berechneten Unterschiedswerte mit Datum- und Uhrzeitstempel in der zweiten Speichereinheit vornimmt.

11. Gerät nach Anspruch 9 oder 10, **dadurch gekennzeichnet, dass** es eine Ausgangssteckverbindung (19) aufweist, die funktional mit der elektronischen Verarbeitungseinheit verbunden ist, um das Gerät (1) mit einem EDV-Lesegerät (20) des Typs Computer verbinden zu können, um zu diesem die berechneten und mit dem Datum- und Uhrzeitstempel versehenen Unterschiedswerte, die in der zweiten Speichereinheit enthalten sind, zu exportieren.

12. Gerät nach einem der Ansprüche 1 bis 11, **dadurch gekennzeichnet, dass** es die Mittel zum Erzeugen von Spannung (3) erlauben, eine variable Spannung zu erzeugen, deren Amplitude mit Hilfe eines Einstellmittels (21) des Typs Potentiometer ausgewählt werden kann.

13. Gerät nach einem der Ansprüche 1 bis 12, **dadurch gekennzeichnet, dass** die elektrischen Anschlussmittel (4) aus mindestens zwei Leitern (5, 6) bestehen, die mit Enden (5A, 5B, 6A, 6B) abschließen, die eine elektrischen Verbindung durch Kontakt erlauben.

14. Gerät nach einem der Ansprüche 1 bis 13, **dadurch gekennzeichnet, dass** es einen Sockel (24) aufweist, der die Anschlussmittel (4) enthält, wobei der Sockel funktional mit den Messmitteln verbunden und eingerichtet ist, um abnehmbar zu ihrem Überwachen eine Patrone (7) zum Schutz für Anlagen vor Überspannungen aufzunehmen, wobei die Patrone (7) mindestens einen Varistor aufweist und mit elektrischen Anschlussmitteln (8) versehen ist.

15. Gerät nach Anspruch 14, **dadurch gekennzeichnet, dass** der Sockel (24) eine Aufnahme (25) aufweist, die die Patrone (7) aufnehmen kann, wobei die Aufnahme mit elektrischen Kontaktmitteln ergänzend zu den Anschlussmitteln (8) der Patrone (7) versehen ist, wobei die elektrischen Kontaktmittel die Anschlussmittel (4) bilden.

16. Gerät nach Anspruch 5, **dadurch gekennzeichnet, dass** es ein tragbares Gehäuse (40) aufweist, in welchem die Spannungserzeugungsmittel (3), die Messmittel, die elektronische Verarbeitungseinheit und das Anzeigemittel eingerichtet sind.

17. Verfahren zum Prüfen der Alterung eines Varistors (2) durch Anlegen einer Spannung zwischen den Klemmen (2A, 2B) des Varistors (2), wobei das Verfahren Folgendes umfasst:
- einen Schritt (a) des Messens eines ersten Werts des Widerstands des Varistors (2) und/oder der Stärke des Stroms, die ihn durchquert, wenn eine erste Spannung (U₁) an die Klemmen (2A, 2B) des Varistors (2) gemäß einer ersten Polung (P₁) angelegt wird, wobei der erste Wert einen ersten Messwert bildet,
- einen zweiten Schritt (b) zum Messen eines zweiten Werts des Widerstands des Varistors (2) und/oder der Stärke des Stroms, die ihn durchquert, wenn eine zweite Spannung (U₂) an die Klemmen (2A, 2B) des Varistors (2) gemäß einer zweiten Polung (P₂) angelegt wird, wobei die zweite Polung (P₂) zu der ersten Polung (P₁) entgegengesetzt ist, und wobei der zweite Wert einen zweiten Messwert bildet,
- und einen Schritt (c) des Vergleichens des ersten und des zweiten Messwerts.

18. Verfahren nach Anspruch 17, **dadurch gekennzeichnet, dass** der zweite Spannungswert (U₂) einen Absolutwert gleich dem des ersten Spannungswerts (U₁) besitzt.

19. Verfahren nach Anspruch 17 oder 18, **dadurch gekennzeichnet, dass** es einen Schritt (d) des Berechnens eines berechneten Unterschiedswerts aufweist, der einem Unterschied zwischen dem ersten und dem zweiten Messwert entspricht.

20. Verfahren nach Anspruch 19, **dadurch gekennzeichnet, dass** es einen Schritt (e) des Anzeigens des ersten Messwerts und/oder des zweiten Messwerts und/oder des berechneten Unterschiedswerts aufweist.

21. Verfahren nach Anspruch 19 oder 20, **dadurch gekennzeichnet, dass** es einen Schritt (f) des Vergleichens zwischen dem berechneten Unterschiedswert und einem vorausbestimmten und gespeicherten Schwellenwert aufweist.

22. Verfahren nach einem der Ansprüche 19 bis 21, **dadurch gekennzeichnet, dass** das Bestimmen des ersten und des zweiten Werts und des berechneten Unterschiedswerts verwendet wird, um die Überwachung der Alterung eines Varistors (2) sicherzustellen, der in einer elektrischen Anlage (50) installiert ist.

23. Verfahren nach Anspruch 22, **dadurch gekennzeichnet, dass** es Folgendes umfasst:
- einen Schritt (g) des Speicherns in einem Speicher des ersten und des zweiten Messwerts mit Datum- und Uhrzeitstempel sowie des berechneten Unterschiedswerts, wobei der aus den Schritten (a) bis (g) gebildete Erfassungszyklus regelmäßig gemäß einer Erfassungsfrequenz wiederholt wird,
- einen Schritt (h) zum Exportieren der mit einem Datum- und Uhrzeitstempel versehenen Informationen, die in dem Speicher enthalten sind, zu einem EDV-Lesegerät (20), wobei dieser Schritt (h) regelmäßig gemäß einer Rückgewinnungsfrequenz durchgeführt wird, die größer als oder gleich der Erfassungsfrequenz ist,
- einen Schritt (i) der Verarbeitung der Informationen mit Datum- und Uhrzeitstempel, die mit Hilfe eines EDV-Programms exportiert werden, um Informationen zur zeitlichen Überwachung der Alterung des Varistors (2) zu erhalten.
